# EUROPÄISCHE PATENTSCHRIFT

(11) **EP 0 563 597 B1**
(45) Veröffentlichungstag und Bekanntmachung des Hinweises auf die Patenterteilung: **22.09.1999**
(21) Anmeldenummer: 93103338.5
(22) Anmeldetag: 03.03.1993
(51) Int. Cl.: G06F 17/50

(54) **Asic-Prototyper**
Asic-prototyper
Asic pour prototypage

(30) Priorität: 31.03.1992 DE 4211162
(43) Veröffentlichungstag der Anmeldung: 06.10.1993
(73) Patentinhaber: Zeiner, Manfred, Dipl.-Ing., D-13593 Berlin (DE); Budini, Michael, Dipl. Phys., 10625 Berlin (DE)
(72) Erfinder: Zeiner, Manfred, Dipl.-Ing., D-13593 Berlin (DE); Budini, Michael, Dipl. Phys., 10625 Berlin (DE)

(56) Entgegenhaltungen:
- WO-A-90/04233

## Beschreibung

Die Erfindung bezieht sich auf einen in Hardware ausgeführten elektronischen ASIC-Prototyper, der es ermöglicht, integrierte Schaltkreise bzw. ASIC's zu emulieren, so daß ein Testen des zu schaffenden Bausteins in der späteren Hardware-Umgebung möglich ist.

Die CMOS-Technologie erlaubt es Elektronikentwicklern, ganze Systeme in digitaler Technik auf einem integrierten Schaltkreis zu realisieren. Die Entwicklung eines komplexen Schaltkreises wird durch eine Vielzahl automatischer Verfahren unterstützt, welche einigermaßen sicher anzuwenden sind, falls die notwendigen Regeln beachtet werden. Am Anfang einer Entwicklung steht die Spezifikation des zu schaffenden Bausteins. Hier werden die genaue Funktion mit dem logischen Verhalten und die notwendigen mechanischen, physikalischen und elektrischen Randbedingungen beschrieben und festgelegt. Falls keine komplette Eigenentwicklung eines integrierten Schaltkreises beabsichtigt ist, so ist das Ziel ein ASIC, das in der Geräteumgebung exakt den gewünschten Spezifikationen entspricht. Für Anwendungen mit größeren Stückzahlen sind zur Zeit die maskenprogrammierten ASIC-Technologien die wirtschaftlichste Lösung zur Erfüllung der meisten Spezifikationen. Dabei kommen die ASICs in den Formen eines Gate-Arrays, eines Sea-of-gates ASICs oder Cell-Arrays zum Einsatz. Die drei Formen unterscheiden sich voneinander durch die geometrische Anordnung ihrer inneren Logikblöcke, die miteinander frei verbunden werden können. Die Entwicklung oder das Design der ASICs erfolgt durch eine eingehende Simulation vor der kostenintensiven Fertigung. Dabei bedeutet Simulation eines Designs die Ausführung eines Algorithmus, der das Verhalten der gewünschten Schaltung modellhaft beschreibt. Dies eröffnet die Möglichkeit, ein Design zu analysieren und zu verifizieren, ohne eine Hardware-Ausführung zu erstellen. Als Schnittstelle zwischen dem Anwender und dem eigentlichen Hersteller des ASICs dient eine Netzliste, mit der die Funktion der Schaltung durch eine Verbindungsliste von Bibliothekselementen des gewählten Herstellers eindeutig beschrieben wird. Die einzelnen Bibliothekselemente beschreiben einfache und komplexe logische Grundschaltungen und Verknüpfungen. Die Erzeugung der Netzliste kann auf zweierlei Art geschehen, entweder durch die Eingabe des Schaltplans oder durch die Eingabe einer Verhaltensbeschreibung, beispielsweise durch eine Wahrheitstafel, mit einer anschließenden Schaltungssynthese. Beide Verfahren sind zudem miteinander mischbar. Die Überprüfung der Netzliste erfolgt mit Hilfe von Simulatoren. Den Bibliothekselementen werden softwaremäßig Modelle zugeordnet, die das spätere Verhalten möglichst genau nachbilden sollen. Somit steht die gesamte Schaltung als Softwaremodell vorab zur Verfügung, wobei man sich darüber im Klaren sein muß, daß ein Modell benutzt wird, das immer mit Fehlern behaftet sein kann. Die Reaktion dieses Modells wird durch das Anlegen von Stimulus-Pattern mittels eines Logiksimulators geprüft. Ein Stimulus-Pattern bedeutet dabei, daß die Eingänge des Modells mit Eingangsdaten beaufschlagt werden. Der Simulator errechnet die Ausgangswerte. Die Ergebnisse werden mit den geplanten Werten verglichen. Dies führt jedoch nur dann zu einem sicheren Erfolg, wenn die Stimuli den tatsächlichen Bedingungen entsprechen und wenn die überprüften Reaktionen auch alle gewünschten Ergebnisse bringen. Die Gefahr einer Fehlspezifikation der simulierten Schaltung ist bei diesem Verfahren nicht völlig ausgeschlossen. Außerdem sind Simulationsläufe i.a. langsam und benötigen daher große Rechenzeiten und Rechenkapazitäten, so daß das Verfahren auch von daher kostenintensiv ist. Eine derartige Simulation berücksichtigt nicht, in welcher physikalischen Umgebung die Schaltung eingesetzt wird, d.h. Auswirkungen der Hardware-Umgebung, in der die Schaltung eingesetzt werden soll, bleiben unberücksichtigt.

Es ist möglich, die Umgebung der projektierten Schaltung bzw. des ASICs ebenfalls softwaremäßig nachzubilden und in die Simulation einzubinden. Dies ist jedoch nur bedingt möglich, da die Umgebung für den Simulator modellierbar sein muß. Da das Gesamtsystem in den allermeisten Fällen nicht abgeschlossen ist, ist die Modellierung des Gesamtsystems nicht möglich. Somit müssen für das Gesamtsystem wieder Schnittstellen definiert werden, um eine Begrenzung des Gesamtsystems zu erreichen. Die Schnittstellen können wiederum zu Spezifikationsfehlern führen und das Problem wird nur verlagert. Die Erweiterung der Simulation um das begrenzte Gesamtsystem führt zu einem weiteren Anstieg der Simulationsrechenzeiten, ohne daß Fehler sicher ausgeschlossen werden können.

Eine weitere Möglichkeit der Einbeziehung der Umgebung ist die Verwendung eines "Hardware-Modeler"s. Hier wird die Hardware-Umgebung oder Teile davon über Interface-Schaltungen an den Software-Simulator angebunden. Diese werden vom Simulator wie Software-Macros aufgerufen. Allerdings sind die notwendigen Interface-Schaltungen individuell für jede Hardware-Einheit der Umgebung zu erstellen, da die sehr viel schnellere Hardware an die wesentlich langsamere Software durch Zwischenspeichern von allen anfallenden Zuständen angepaßt werden muß. Dieses Verfahren löst zwar das Problem der Spezifikation der Schnittstellen zwischen dem ASIC-Soft-ware-Modell und der Hardware-Umgebung theoretisch, ist aber praktisch wegen der unverhältnismäßig hohen Anpassungsarbeiten, die ebenfalls fehlerbehaftet sein können, nahezu undurchführbar und teuer. In der Praxis werden daher nur Standardelemente, für welche Software-Modelle zu komplex sind, wie z.B. Prozessoren, Controler o.ä., über einen "Hardware-Modeler" in die Simulation eingebunden.

Eine sehr wirkungsvolle Methode zur Überprüfung der Funktionsfähigkeit einer Schaltung in ihrer Umgebung ist nicht die Simulation mit Softwaremodellen, sondern die Hardware-simulation, d.h. die einzelnen Unterelemente des ASICs werden durch Hardwaremodelle ersetzt. Man spricht dabei von einer Emulation. Bekannt ist hierbei das "RPM (Rapid Prototype Maschine) Emulation System", dessen Wirkungsweise in der EP-OS 0 372 833 beschrieben ist. Das System basiert auf sog. Logic Cell Arrays (LCA) als Hardwaregrundlage, welche z.B. von der Fa. XILINK angeboten werden. Das sind Bauelemente, die aus einer Matrix von konfigurierbaren Logikblöcken, konfigurierbaren I/O-Zellen und einer konfigurierbaren Verdrahtung bestehen. Die Konfigurierbarkeit wird durch Speicherzellen, die als Memory Teil des LCA's sind, erreicht. Bei der Emulation wird nun die softwaremäßig simulierte Netzliste des projektierten ASICs entsprechend übersetzt, in eine Anordnung der LCA's übertragen und dort hardwaremäßig abgebildet. Die Ein- und Ausgänge des Emulators (LCA-Anordnung) entsprechen nun den Anschlüsen des emulierten ASICs und werden direkt über Adapter in die Umgebungsschaltung des ASICs eingeschlossen. Die Funktion der emulierten Schaltung kann daher direkt in der eigentlichen Umgebung getestet werden.

### Einfügung in die Beschreibung

Weiterhin ist in der Druckschrift WO 90/04233 ein Hardware-System zur "Simulation" und zum "Prototyping" beschrieben. Dieses besteht ebenfalls aus einer Vielzahl von miteinander zu Logikblöcken verbundenen, konfigurierbaren Logik-Chips und einer konfigurierbaren Verdrahtung. Auch hier wird das Hardware-System zur schnellen Bestimmung der funktionalen Ergebnisse eines angelegten Input-Patterns herangezogen. Dieses System zeichnet sich dadurch aus, daß die vorhandenen Logik-Chips sowohl zum Abbilden der ursprünglichen, funktionalen Netzliste, als auch mittels entsprechend modifizierter Netzliste zu einer gegenüber einer Softwarelösung beschleunigten, seriellen Fehler-Simulation herangezogen werden können. Darüber hinaus können Teile der Logik-Chips dazu benutzt werden, die aus Software-Simulatoren bekannten, sogenannten "Unit"-Delays abzubilden, indem serielle Schieberegister oder vorprogrammierte zählergesteuerte "state machine"s gebildet und zu der Netzliste hinzugefügt werden. Die aus den Software-Simulatoren bekannte "cycle time" wird dann durch einen gemeinsamen, globalen System-Takt erzeugt.

Nachteilig bei der Emulation des ASICs mit Hilfe von LCA's oder anderen FPGA's (Field Programmable Gate Arrays), wie unter EP-OS 0 372 833 beschrieben, ist, daß die Modellierung der ASIC-Elemente nur funktional, also in der logischen Abfolge, aber nicht in ihrem Zeitverhalten erfolgen kann. So werden die Signallaufzeiten und ihre Verhältnisse untereinander nicht berücksichtigt und können bei dem gattungsgemäßen Emulationssystem nicht kontrolliert werden. Im Verfahren nach WO 90/04233 ist es möglich in vorher ausgewählten "kritischen" Bereichen durch "UNIT"-Delays repräsentierende Logik-Chips zu einer genaueren Abbildung zu gelangen, Allgemein bei allen auf LCA-ähnlichen Technologien basierenden Verfahren, treten darüberhinaus weitere systembedingte Probleme auf So müssen in ungünstigen Fällen manuelle Eingriffe in die Verdrahtungsstrategie der LCA's erfolgen, um die Funktionsfähigkeit der emulierten Schaltung herzustellen. Daraus folgt, daß mit den gattungsgemäßen Systemen eine vollständige Überprüfung und ein vollständiges Testen des projektierten ASICs nur bedingt möglich sind, da das Zeitverhalten der Abbildung gesondert und explizit berücksichtigt werden muß. Die Gefahr eines kostenintensiven Redesigns ist dabei nicht ausgeschlossen. Ein weiterer erheblicher Nachteil der bekannten Emulationen ergibt sich aus der Tatsache, daß die internen Zustände der abgebildeten Knoten der Schaltung nur durch ebenfalls vorherige explizite Verdrahtung an einen Pin des LCA's erfolgen kann. Mit anderen Worten, die Zustände an den Knoten der Schaltung können nicht verändert und an den nicht vorher ausgewählten Knoten auch nicht beobachtet werden. Bei einer notwendigen Fehlersuche ist dieser Umstand sehr nachteilig, da zur Uberprüfung eines nicht nach außen verdrahteten Knotens eine neue Abbildung der gesamten ASIC-Netzliste mit allen oben genannten Schwierigkeiten und Unwägbarkeiten des Zeitverhaltens erfolgen muß.

Der Erfindung liegt daher die Aufgabe zu Grunde, ein System zur Emulation von elektronischen Hardwaresystemen zu schaffen, welches eine vollständige Emulation unter Einbeziehung des Zeitverhaltens der zu entwickelnden Schaltung ermöglicht.

Die Lösung der Aufgabe ergibt sich durch die kennzeichnenden Merkmale des Anspruches 1. Durch das erfindungsgemäße Hinzufügen von freiprogrammierbaren Delay-Elementen in die Logikzellen ist es nunmehr möglich, auch das Zeitverhalten der zu entwickelnden Schaltung in der Emulation zu berücksichtigen. Somit wird ein vollständiger Test eines ASICs durch eine Emulation möglich.

Weitere vorteilhafte Ausgestaltungen der Erfindung ergeben sich aus den Unteransprüchen. So ist für jede Eingangs-signaleinheit einer Logikzelle oder FPE-(Field Programmable Emulation) Zelle ein programmierbares Delay-element vorhanden, um jede Leitung individuell in ihrem Zeitverhalten einstellen zu können. Die Eingangssignale der zu emulierenden Anordnung stehen am Verdrahtungsbus der Logik-Zelle, der aus n-Leitungen besteht, auf einer der Leitungen an. Über den Eingangsmultiplexer jedes Einganges, der über eine RAM-Ansteuerung zur richtigen Busleitung durchschaltet, wird das Eingangssignal in die Logik-Zelle, in der die Logikverknüpfung stattfinden soll, eingekoppelt. Durch eine entsprechend feine Abstufung des Delay-Elementes kann das Eingangssignal variabel verzögert werden. Der am Ende jeder Eingangssignalleitung liegende Multiplexer schaltet in Abhängigkeit eines Steuersignals, das aus dem entsprechenden RAM-Speicher kommt, entweder das Eingangssignal oder einen festen Logikzustand als Eingangswert zur wählbaren Logikfunktionseinheit durch. Dieser Input hat eine Verbindung nach außen und kann somit von außen auf seinen logischen Zustand abgefragt werden. Die n-Eingänge gehen auf eine frei konfigurierbare Logikfunktionseinheit. Die Logikfunktionseinheit ist mit einem RAM-Speicher verbunden, so daß darüber unterschiedliche Logikgrundfunktionen wie AND's, NAND's, OR's, NOR's XOR's, XNOR's etc. und Latchfunktionen eingestellt werden können. Damit können relativ einfach Elemente einer Netzliste bei der ASIC-Emulation nachgebildet werden. Der Ausgang der Logikfunktionseinheit führt auf einen Multiplexer, dessen Steuerleitung mit einem RAM verbunden ist. Dadurch ist es möglich, entweder das Ausgangs-signal der Logikfunktionseinheit oder einen Eingang unter Umgehung der Logikeinheit auf den Ausgang zu schalten. Diese Anordnung bietet die Möglichkeit, die angesteuerte FPE-Zelle nicht als Logikelement mit den dazugehörigen Verzögerungen zu betreiben, sondern die FPE-Zelle als zusätzliche Verdrahtungsmöglichkeit ohne Schalt- oder sonstige Verzögerungen zu nutzen. Der Ausgang des Ausgangsmultiplexers kann ebenso wie die bereits erwähnten Eingänge der Logikfunktionseinheit von außen über ein Ausleseschaltung abgefragt werden. Dadurch ist es möglich, nur durch eine einfache Softwareabfrage zu jeder Zeit den Zustand eines beliebigen Knotens oder Verdrahtungselements einer abgebildeten Schaltung festzustellen. Die Ausgangsleitung einer Logik-Zelle ist weiterhin mit einem fein abstufbaren Delay-Element versehen, so daß das Zeitverhalten der Logikelemente und der Verdrahtungsteilstücke abgebildet werden kann. Der Ausgang der gesamten FPE-Zelle wird über einen n-stufigen Demultiplexer an den Verdrahtungsbus gegeben, um von dort an Eingänge von anderen FPE-Zellen zu gelangen. Die Breite n des Verdrahtungsbusses hängt von der Topologie der gesamten FPE-Anordnung, d.h. eines FPE-Moduls, ab.

Stellt man eine genügend große Anzahl von FPE-Zellen und einen genügend breiten Verdrahtungsbus zur Verfügung, so kann jede Schaltung, die durch eine frei programmierbare Logikfunktion darstellbar ist, mit allen Verzögerungszeiten abgebildet und somit emuliert werden. Gleichzeitig können alle Knoten der Schaltung auf ihren Logikzustand im Betrieb abgefragt werden. Weiterhin erlaubt die erfindungsgemäße Anordnung, daß jeder Eingang eines verwendeten Logikelementes auf einen definierten Zustand gesetzt werden kann.

Um möglichst hohe Frequenzen der mit dieser Anordnung emulierten Schaltung zu erreichen, müssen möglichst viele FPE-Zellen auf kleinstem Raum zusammengefaßt werden. Dies kann mit den heutigen Integrationstechniken bis zu einem gewissen Maß erreicht werden. Da mit steigender Integrationsdichte die Ausbeute an funktionierenden FPE-Zellen auf einem Träger sinkt, ist man gezwungen, die Gesamtheit aller FPE-Zellen in Module aufzuspalten, den FPE-Modulen. Mehrere FPE-Module werden zusammengefaßt und bilden die sog. ASIC-Box. In der ASIC-Box werden mehrere FPE-Module entweder durch eine direkte Verdrahtung oder über frei programmierbare Koppelfelder miteinander verknüpft. Erfindungsgemäß sind die Signalleitungen der frei programmierbaren Koppelfelder ebenfalls mit einstellbaren Delay-Elementen versehen, so daß ein Verdrahten beliebiger FPE-Module unter der Modelliermöglichkeit der Laufzeiten einer Verbindung möglich ist. Dies ist einfacher, als über die Delayeinstellungen der internen Verdrahtung der FPE-Zellen die Laufzeiten von beispielsweise Busverbindungen etc. nachzubilden. Die Programmierung der Delay-Elemente der Koppelfelder erfolgt ebenso über RAM's wie bei den internen Delay-Elementen der internen FPE-Zellen. Die Kreuzungspunkte der Signalleitungen der Koppelfelder sind wiederum über RAM's programmierbar, d.h. eine Verbindung kann durchgeschaltet werden oder nicht.

Die Erfindung ist nachfolgend anhand einer in den Zeichnungen dargestellten bevorzugten Ausführungsform beschrieben. Es zeigen:
- Fig.1: das Schema eines Schaltungsentwurfes,
- Fig.2: den Ablauf einer Schaltungsimulation,
- Fig.3: das Prinzipbild einer Hardware-Emulation,
- Fig.4: das Blockschaltbild einer erfindungsgemäßen FPE-Zelle,
- Fig.5: den Aufbau eines erfindunggemäßen FPE-Moduls,
- Fig.6: den Systemaufbau einer ASIC-Box und
- Fig.7: das Blockschaltbild eines erfindungsgemäßen Koppelfeldes.

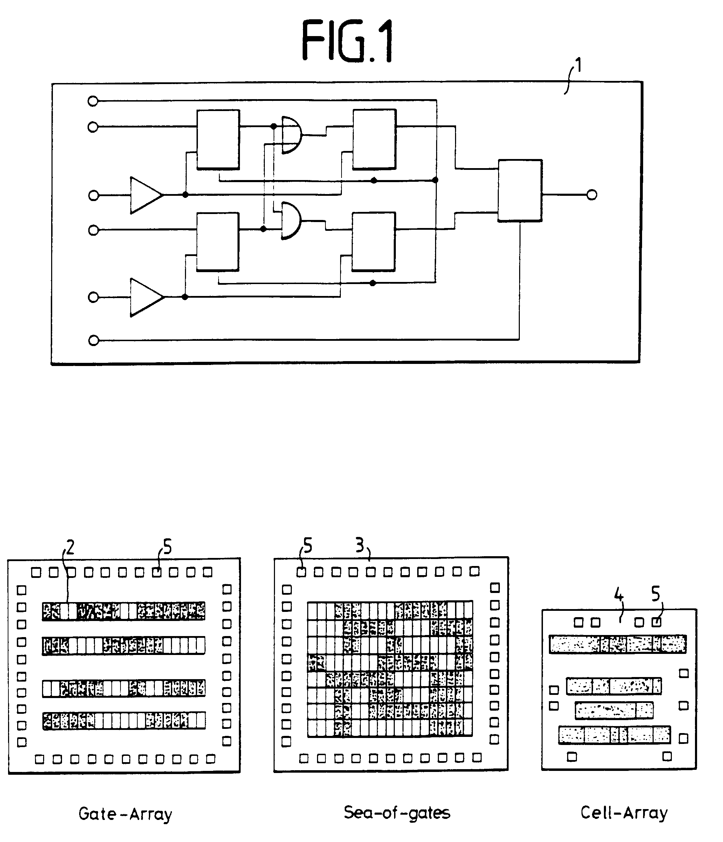

Die Fig. 1 zeigt in seiner oberen Hälfte einen beliebigen Stromlaufplan 1. Dieser beispielhafte Schaltungsentwurf soll in einem ASIC realisiert werden. Als ASICs kommen Gate-Arrays 2,Sea-of-Gates 3 oder Cell-Arrays 4 in Betracht, die alle unter den Oberbegriff digitale, maskenprogrammierte ASICs fallen.

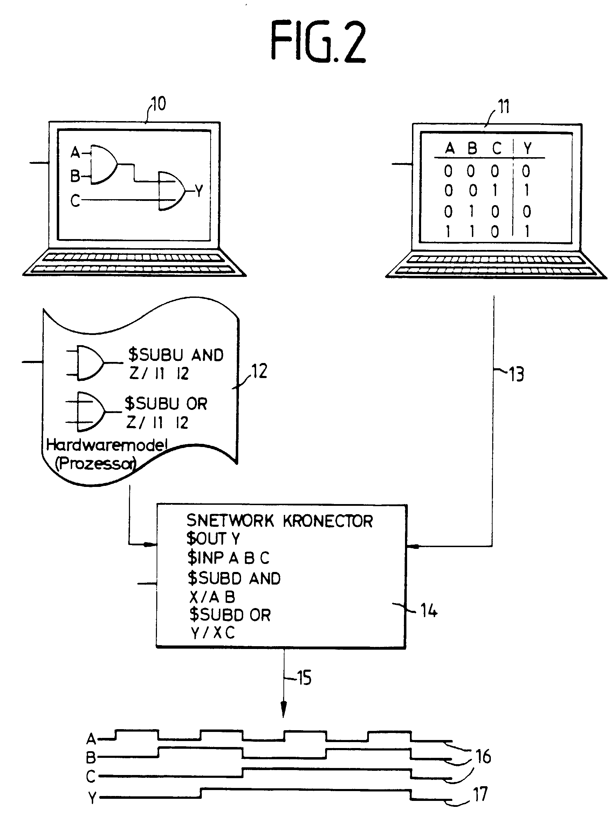

Die Fig. 2 zeigt den üblichen Ablauf einer Schaltungsent-wicklung bis zur Softwaresimulation der projektierten Schaltung. Am Anfang einer Entwicklung steht die Erstellung eines Schaltplanes. Dieser wird über eine Schaltplaneingabe 10 in ein EDV-System eingegeben. Dort wird der Schaltplan mittels vom ASIC-Hersteller bereitgestellter Bibliothekselemente 12 in eine Netzwerkliste umgewandelt. Die Bibliothekselemente 12 beschreiben logische Grundverknüpfunge o.ä. Den Bibliothekselementen werden Modelle softwaremäßig zugeordnet, die das spätere Verhalten in Hardware möglichst genau beschreiben sollen. Es folgt somit eine Simulation 15 der gewünschten Schaltung. Zu dieser Simulation 15 gelangt man auch auf einem zweiten Weg, in dem eine Verhaltensbeschreibung 11 in das EDV-System eingegeben wird. Zusammen mit einer Logik-synthese 13 wird die Netzliste 14 erstellt. Ausgehend von der Netzliste wird auch hier ein Simulationsmodell 15 erzeugt. Mittels eines Stimulus-Pattern 16 werden die Eingänge des Softwaremodells mit Daten belegt. Die Simulation führt dann zu einem Simulationsergebnis 17, das mit den gewünschten Daten verglichen werden kann.

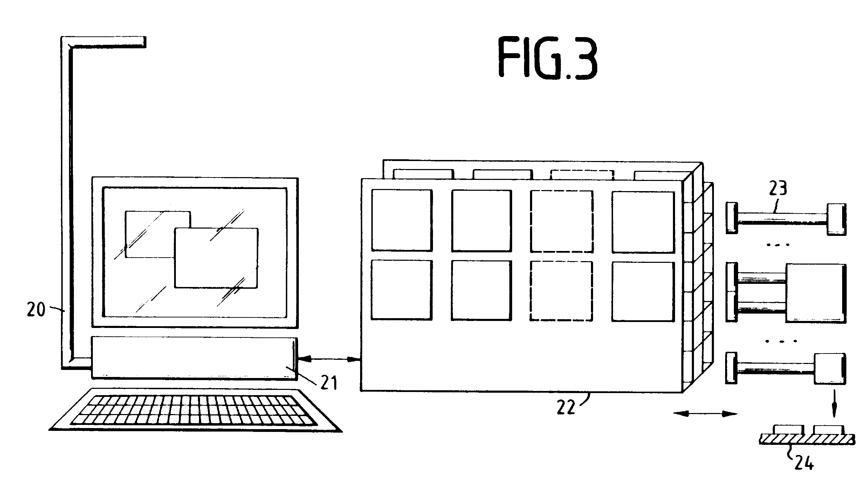

Die Fig. 3 zeigt das Prinzipbild eines ASIC-Emulators. Durch eine Datenübertragung 20 werden die Netzliste, die benötigte Bibliothek und die gewünschte Pinbelegung des ASICs in eine EDV-Anlage 21 eingebracht. Die EDV-Anlage 21 führt die Verwaltung des Man-Maschine Interface durch, erstellt die Plazierung- und Verdrahtungsdaten für den Emulator 22 nach der entsprechenden Vorschrift und überträgt die Plazierungs- und Verdrahtungsdaten physikalisch in den Emulator 20, so daß in diesem ein hardwaremäßiges Abbild der gewünschten Schaltung vorhanden ist. Der Emulator 20 reagiert folglich wie das projektierte ASIC, so daß mit diesem Tests auf Funktionsfähigkeit etc. durchgeführt werden können. Der Emulator ist mit einer PIN-Adapter-Einheit 23 ausgerüstet, wobei der Emulator 22 in dem Target-System 24, d.h. in der Hardware-Umgebung, in der ASIC eingesetzt werden soll, plazierbar ist.

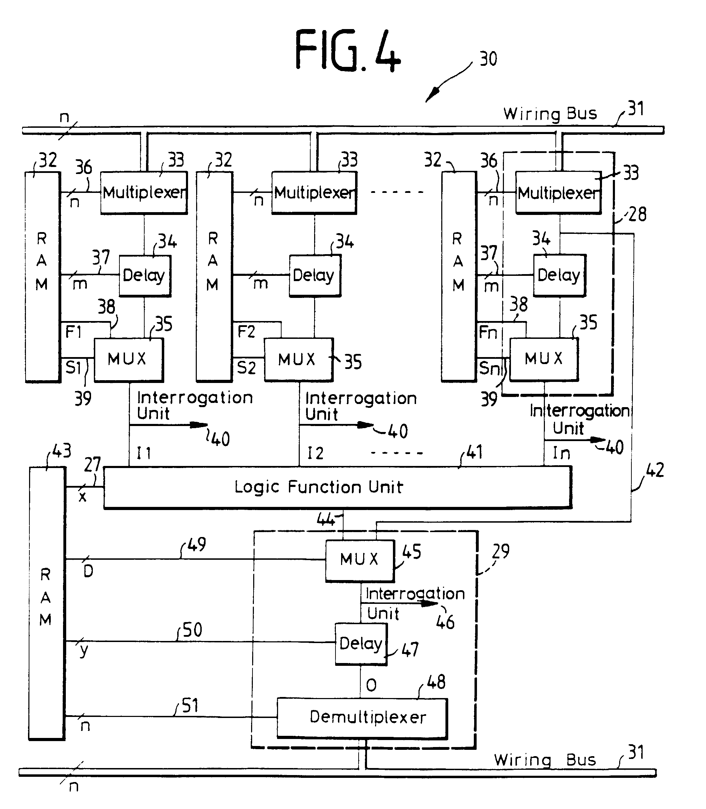

Die Fig.4 zeigt das Blockschaltbild einer Logik-Zelle 30 der FPE Field Programmable Emulation, d.h. eine FPE-Zelle. Eine FPE-Zelle 30 enthält Anschlüsse für den Verdrahtungsbus 31, der aus n Leitungen besteht. Die Anzahl n richtet sich nach der Anwendung und ist größer gleich 1. Über einen Multiplexer 33 werden die Eingangssignale auf die entsprechende Eingangseinheit 28 geschaltet. Es existieren n Eingangseinheiten 28. Eine Eingangseinheit 28 umfaßt den bereits erwähnten Multiplexer 33, eine nachfolgende Delay-Einheit 34 und einen weiteren Multiplexer 35, wobei die Elemente der Eingangseinheit 28 von einem RAM-Speicher 32 gesteuert werden. N Steuerleitungen 36 gehen an den Multiplexer 33, m Steuerleitungen 37 steuern die zeitliche Auflösung der Delay-Einheit 34 und eine Selectleitung 39 verbindet ein Bit des RAM-Speichers 32 mit dem zweiten Multiplexer 35. Weiterhin bilden der Ausgang der Delay-Einheit 34 und eine Signalleitung 38 des RAMs 32 die Eingänge des Multiplexer 35. Damit wird erreicht, daß in Abhängigkeit vom Zustand der Selectleitung 39 die Logikfunktioneinheit entweder mit dem vom Verdrahtungsbus 31 kommenden Eingangssignal oder mit einem aus dem RAM 32 kommenden Festsignal beaufschlagt wird. Zwischen den Multiplexern 35 und der Logikfunktionseinheit 41 ist eine Abfrage 40 vorgesehen,sodaß der logische Zustand von der Logikfunktionseinheit 41 kontrolliert werden kann. Die n Ausgänge der Eingangseinheiten 28 gelangen in die Logikfunktionseinheit 41. In dieser werden in Abhängigkeit von einem RAM-Speicher 43 die logischen Grundfunktionen, Latches etc. eingestellt. Das Ergebnis der logischen Operation gelangt über einen Ausgang 44 in einen Multiplexer 45 der Ausgangseinheit 29. Die Ausgangseinheit 29 umfaßt die Elemente Multiplexer 45, Abfrageeinheit 46, Delay-Einheit 47 und Demultiplexer 48. Die Logikfunktionseinheit 41 und die Elemente der Ausgangseinheit 29 außer der Abfrageeinheit 46 werden von dem RAM-Speicher 43 mit Daten versorgt bzw. gesteuert. Dazu sind die Steuerleitungen 27, 49, 50 und 51 entsprechend Fig. 4 vorgesehen. Der Ausgang 44 der Logikfunktionseinheit 41 und die Überbrückungsleitung 42 bilden die zwei Eingänge des Multiplexers 45. Dabei verbindet die Überbrückungsleitung 42 eine Eingangseinheit 28 direkt unter Umgehung der Logikfunktionseinheit 41 mit der Ausgangseinheit 29, wobei der Abgriff der Überbrückungsleitung 42 direkt hinter dem Multiplexer 33 erfolgt. Je nach Ansteuerung des Multiplexers 45 durch die Steuerleitung 49 wird entweder das Ausgangssignal der Logikfunktionseinheit 41 oder das nicht verzögerte, unveränderte Eingangssignal durchgeschaltet. Dies eröffnet die Möglichkeit, eine FPE-Zelle als reine Leitung zu benutzen. Mittels der Abfrage 46 kann der Ausgang der Logik-Zelle 30 überprüft werden. Weiterhin ist am Ausgang des Multiplexers 45 eine steuerbare Delay-Einheit 47 mit y Steuerleitungen 50 angeschlossen. Damit kann bei einer Emulation das Zeitverhalten der Logikausgänge und von Verdrahtungsteilstücken feinstufig abgebildet werden. Der Ausgang O der Delay-Einheit 47 wird über den, mittels n-Steuerleitungen 51 angeschlossenen, n-stufigen Demultiplexer 48 an den Verdrahtungsbus 31 gegeben, um von dort an die Eingänge der anderen FPE-Zellen zu gelangen. Die Breite n des Verdrahtungsbus 31 hängt von der Topologie der gesamten FPE-Zellenanordnung ab.

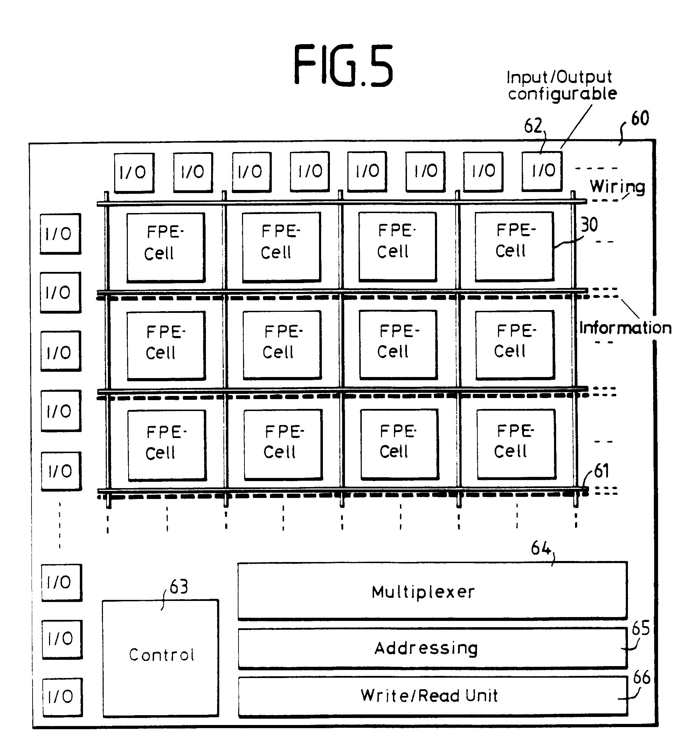

Die Fig.5 zeigt den Zusammenschluß einer Vielzahl von FPE-Zellen zu einem FPE-Modul 60. Das FPE-Modul 60 besteht aus FPE-Zellen 30, die auf einem Träger in Matrixform angeordnet sind. Die einzelnen Zellen 30 werden durch einen Verdrahtungsbus 61 miteinander verbunden. Weiterhin umfaßt ein FPE-Modul eine Vielzahl von I/O-Einheiten 62, die konfigurierbar sind. In dem Chip "FPE-Modul" befinden sich noch ein Controler 63, ein Multiplexer zur Abfrage des Zellstatus 64, eine Adressierung 65 der Multiplexer zur Informationsabfrage der FPE-Zellen und RAMs der Logikzellen und eine Schreib-/Leseeinheit 66.

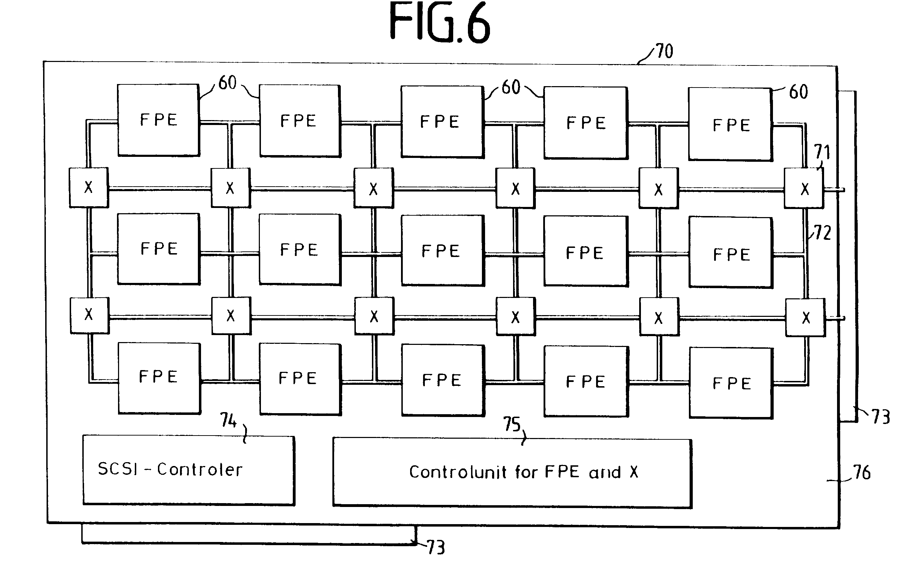

In Fig. 6 ist der Systemaufbau einer "ASIC-Box" 70 dargestellt. Eine Vielzahl von FPE-Modulen 60 sind in Matrixform auf beispielsweise einer Platine 76 aufgebracht. Die einzelnen FPE-Module sind untereinander über Koppelfelder 71 und die nötige Verbindungen 72 derart verbunden, daß jede Logik-Zelle letztlich mit einer beliebig anderen verbunden werden kann. Weiterhin wird eine Steuereinheit 75 zur Steuerung der FPE-Module 60 und der konfigurierbaren Xoppelfelder 71 in der ASIC-Box 70 benötigt. Zum Anschluß der ASIC-Box 70 an eine EDV-Anlage dient ein SCSI-Interface 74.

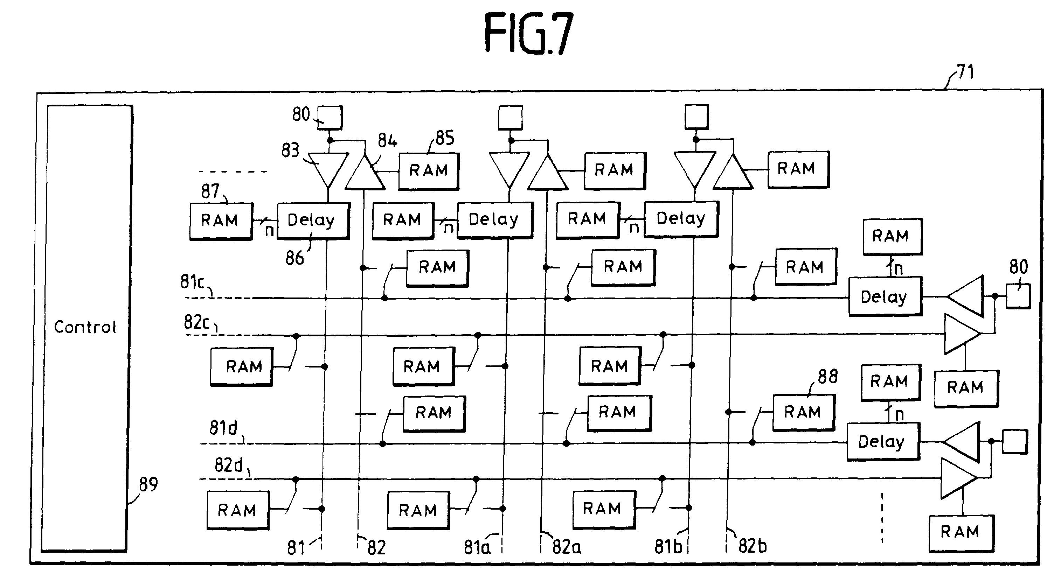

Die Fig.7 zeigt ein Prinzipschaltbild der konfigurierbaren Koppelfelder 71. Jeder Anschlußpunkt 80 eines Koppelfeldes 71 spaltet sich auf in zwei gegenläufige Signalleitungen 81 und 82, deren Signalrichtung durch die richtungsabhängigen Ein- und Ausgangsverstärker 83 und 84 bestimmt werden, wobei die Ausgangsverstärker 84 von einem RAM 85 in den getriebenen Zustand oder in den High-Impedance-Zustand gesteuert werden. Jede Signalleitung 81 enthält eine Delay-Einheit 86, die über ein RAM 87 gesteuert wird. Weiterhin ist jeder Kreuzungspunkt einer Signalleitung mit einer entsprechenden anderen der richtigen Richtung mittels eines RAMs 88 programmierbar in dem Sinne, daß entweder eine Verbindung der Kreuzungspunkte hergestellt wird oder nicht.

Die folgenden Anwendungen kommen für die vorstehend beschriebene Hardware-Anordnung, den "ASIC-Prototyper", in Betracht. Es lassen sich auf dem Prototyper Netzwerke von ASICs und anderen logischen Schaltungen abbilden, wobei die Logik und das Zeitverhalten der Logikelemente und deren Verbindungen untereinander modelliert werden können. Die Variabilität wird durch die softwaremäßige Einstellung der RAM-Struktur erreicht. Damit ist es möglich, die Funktion eines ASICs vor dessen Fertigstellung zu emulieren und in der richtigen Umgebung zu testen. Die eingebaute Fähigkeit, die logischen Zustände beliebiger Knoten abzufragen, erleichtert die Fehlersuche erheblich, wenn die Funktionsfähigkeit der emulierten Schaltung in ihrer Umgebung nicht erfüllt ist.

Weiterhin läßt sich der ASIC-Prototyper zur Fehlersimulation einsetzen. Bei der Fertigung von ASICs treten grundsätzlich Defekte auf, die beim anschließenden Test erkannt werden müssen. Da es nicht möglich ist im Innern eines IC zu messen, muß dafür Sorge getragen werden, daß alle internen Knoten steuerbar und kontrollierbar sind. Weiterhin muß es ein Testpattern geben, daß alle möglichen Fehlerquellen erkennt. Dazu gibt es ein Fehlermodell, das nahezu alle Fehlerarten abdeckt. Das ist die "Stuck at 1 und Stuck at 0-Methode". Man geht davon aus, daß man jeden internen Knoten einmal auf logisch 1 und dann auf logisch 0 zwingt. Durch die Reaktion am Ausgang des IC's wird nun festgestellt, ob dieser Fehlereingriff erkannt wird oder nicht. Bisher werden solche Analysen an Softwareabbildungen mit Hilfe eines Fehlersimulators durchgeführt. Da jeder Fehler einen ganzen Simulationslauf bedeutet, sind bei großen ASIC's und langen Testpattern die Ausführungszeiten auch mit schnellsten Rechnern extrem lange und gehen in die Tage. So wird versucht durch eine statistische Fehlersimulation durch eine statistische Auswahl von Knoten die Laufzeit zu verkürzen. Eine exakte Aussage über die wirkliche Fehlerabdeckung ist damit jedoch nicht möglich. Mit der Fähigkeit des erfindungsgemäßen Prototypers, alle Knoten auf einen beliebigen gewünschten Zustand zu setzen, ist eine "Fehleremulation" anstelle einer Fehlersimulation mit wesentlich geringerem Zeitaufwand zu erreichen und ergibt eine exakte Aussage über das Verhalten des geplanten ASIC's im Falle von Fertigungsfehlern. So kann leicht aus dem Verhalten des Prototypers im Fehlerfall eine Änderung der Schaltung selbst oder eine Erweiterung des Testpattern abgeleitet werden, was zu einem sicheren Testen nach der Fertigung führt.

Weiterhin kann es beim Entwurf von Schaltungen vorkommen, daß an einem Logikelement mit mehreren Eingängen zwei Signale in annähernd gleicher Zeit ihren Zustand ändern. Dies hat bei der Takt-Daten-Beziehung eines Flipflops fatale Konsequenzen, da dann unterschiedliche Daten verarbeitet werden. Solche Wettläufe (Race) sind also grundsätzlich zu vermeiden. Auf die gleiche Art und Weise ergeben sich "skew"-Probleme. Hier sind viele Flipflops an einen gemeinsamen Takt angeschlossen. Bei sehr schnellen Halbleitertechnologien bewegt sich die Schaltzeit eines Flipflops in der gleichen Größenordnung wie die Laufzeit auf der Taktleitung. Dadurch entsteht ein "race"-Problem. Leider sind keine Werkzeuge bekannt, die dieses Problem ausreichend lösen. Mit den variablen Delay-Einheiten des erfindungs-gemäßen Prototypers an jedem Knoten und in den Verbindungsleitungen kann nun leicht eine "race"-Kondition erkannt werden, wenn die Schaltung nach einer Variation der Verzögerungszeiten in positiver und negativer Richtung innerhalb vorgegebener Grenzen zu einem anderen Verhalten führt. Dieses Verfahren führt zu einer sicheren Aussage über das "race"- und "skew"-Verhalten des entworfenen ASIC's.

### BEZUGSZEICHENLISTE

- 1: Stromlaufplan
- 2: Gate-Array
- 3: Sea-of-Gates
- 4: Cell-Array
- 5: Anschlüsse
- 10: Schaltplaneingabe
- 11: Verhaltensbeschreibung
- 12: Bibliothek
- 13: Logiksyntese
- 14: Netzliste
- 15: Simulation
- 16: Stimulus-Pattern
- 17: Ergebnis
- 20: Datenübertragung
- 21: EDV-Anlage
- 22: Hardware-Emulator
- 23: Pin-Adapter
- 24: Target-System
- 27: Steuerleitungen
- 28: Eingangseinheit
- 29: Ausgangseinheit
- 30: FPE-Zelle
- 31: Verdrahtungsbus
- 32: RAM-Speicher (Eingang)
- 33: Multiplexer I
- 34: Delay-Element
- 35: Multiplexer II
- 36: Steuerleitungen Multiplexer I
- 37: Steuerleitungen Deav
- 38: Signalleitung Multiplexer II
- 39: Selectleitung Multiplexer II
- 40: Abfrage
- 41: Logikfunktionseinheit
- 42: Überbrückungsleitung
- 43: RAM-Speicher
- 44: Ausgang Logikfunktionseinheit
- 45: Multiplexer (Ausgang)
- 46: Abfrage
- 47: Delay-Einheit
- 48: Demultiplexer
- 49: Steuerleitungen Multiplexer (Ausgang)
- 50: Steuerleitungen Delay (Ausgang)
- 51: Steuerleitungen Demultiplexer
- 60: FPE-Modul
- 61: Verdrahtungsbus
- 62: I/O-Einheit
- 63: Control
- 64: Multiplexer
- 65: Adressierung
- 66: Schreib/Leseeinheit
- 70: ASIC-Box
- 71: Koppelfeld
- 72: Verbindung Koppelfeld - FPE-Module
- 73: Steckerfeld
- 74: SCSI-Controller
- 75: Steuereinheit
- 76: Platine
- 80: Anschlußpunkt
- 81: Hinleitung
- 82: Rückleitung
- 83: Eingangsverstärker
- 84: Ausgangsverstärker
- 85: RAM
- 86: Delay-Einheit
- 87: RAM (Delay)
- 88: RAM (Kreuzungsteuerung)
- 89: Control

## Patentansprüche

1. Hardware-Emulationssystem, bestehend aus einer Vielzahl von miteinander zu Logikblöcken verbundenen konfigurierbaren Logikzellen, konfigurierbaren I/O-Zellen einer konfigurierbaren Verdrahtung, wobei in jeder Logikzelle (30) programmierbare Delay-Elemente (34,47) eingefügt sind,
**dadurch gekennzeichnet,daß**
jede Ausgangseinheit (29) einer Logikzelle (30) mindestens eine Abfrageeinheit (46), ein Weiteres programmierbares Delay-Element (47) und einen Demultiplexer (48) aufweist.

2. Hardware-Emulationssystem nach Anspruch 1, dadurch gekennzeichnet, daß in jeder Eingangseinheit (28) einer Logikzelle (30) ein programmierbares Delay-Element (34) eingefugt ist.

3. Hardware-Emulationssystem nach Anspruch 2, dadurch gekennzeichnet, daß die Eingangseinheit (28) einer Logikzelle (30) eine Abfrageeinheit (40) enthält.

4. Hardware-Emulationssystem nach Anspruch 1 oder 3, dadurch gekennzeichnet, daß die Delay-Elemente (34,47) über RAMs (32,43) programmiert werden.

5. Hardware-Emulationssystem nach Anspruch 4, dadurch gekennzeichnet, daß eine Eingangseinheit (28) einer Logikzelle (30) von einem Verdrahtungsbus (31) ausgehend einen Multiplexer (33), ein sich anschließendes Delay-Element (34), einen nachfolgenden Multiplexer (35) und eine Abfrageeinheit (40) aufweist, wobei der Multiplexer (33), das Delay-Element (34) und der Multiplexer (35) über ein RAM (32) programmiert werden.

6. Hardware-Emulationssystem nach Anspruch 5, dadurch gekennzeichnet, daß der Ausgang der Eingangseinheiten (28) mit einer wählbaren Logikfunktionseinheit (41) der Logikzelle (30) verbunden ist.

7. Hardware-Emulationssystem nach Anspruch 6, dadurch gekennzeichnet, daß die wählbare Logikfunktionseinheit (41) und der Multiplexer (45), das Delay-Element (47) und der Demultiplexer (48) der Ausgangssignalleitung über ein gemeinsames RAM (43) programmiert werden.

8. Hardware-Emulationssystem nach Anspruch 7, dadurch gekennzeichnet, daß eine Eingangseinheit (28) eine Direktverbindung (42) mit dem Eingang des Multiplexers (45) der Ausgangseinheit (29) der Logikzelle (30) aufweist, sodaß bei entsprechender Programmierung die Logikfunktionseinheit (41) umgangen werden kann.

9. Hardware-Emulationssystem nach Anspruch 8, dadurch gekennzeichnet, daß die Delay-Elemente (34,47,86) innerhalb eines vorgegebenen Bereichs digital abstufbar sind.

10. Hardware-Emulationssystem nach Anspruch 9, dadurch gekennzeichnet, daß eine Vielzahl von Logikzellen (FPE-Zellen) (30) zu FPE-Modulen (60) mittels eines Verdrahtungsbusses (61) zusammengefaßt sind.

11. Hardware-Emulationssystem nach Anspruch 10, dadurch gekennzeichnet, daß mehrere FPE-Module (60) über freiprogrammierbare Koppelfelder (71) miteinander verbunden sind.

12. Hardware-Emulationssystem nach Anspruch 11, dadurch gekennzeichnet, daß die freiprogrammierbaren Koppelfelder (71) mit Delay-Elementen (86) versehen sind.

13. Hardware-Emulationssystem nach Anspruch 12, dadurch gekennzeichnet, daß in jeder Signalleitung (81) eines Koppelfeldes (71) ein Delay-Element (86) eingefügt ist.

14. Hardware-Emulationssystem nach Anspruch 13, dadurch gekennzeichnet, daß jedes Delay-Element (86) mittels eines RAMs (87) programmierbar ist.

15. Hardware-Emulationssystem nach Anspruch 14, dadurch gekennzeichnet, daß jede Kreuzung einer Signalleitung (81,82) des Koppelfeldes (71) mit einer anderen Signalleitung (81,82) des Koppelfeldes (71) über ein RAM (88) programmierbar ist.

16. Hardware-Emulationssystem nach Anspruch 13, dadurch gekennzeichnet, daß die Delay-Elemente (86) fein abstufbar sind.

17. Hardware-Emulationssystem nach einem der vorangehenden Ansprüche, dadurch gekennzeichnet, daß die Eingänge *I*_{*n*} der Logikfunktionseinheit (41) über die Multiplexer (35) an feste logische Potentiale *F*_{*n*} des RAM (32) legbar sind.

## Claims

1. An electronic hardware emulation system, comprising a multitude of configurable logic cells connected with each other to form logic blocks, of configurable I/O-cells and of a configurable wiring, where in each logic cell(30) programmable delay units(34,47) are inserted, characterized in that each output unit(29) of a logic cell(30) is provided with at least one interrogation unit(46), one more programmable delay unit(47) and one demultiplexer(48).

2. An electronic hardware emulation system according to claim 1, characterized in that in each input unit(28) of a logic cell(30), a programmable delay unit(34) is inserted.

3. An electronic hardware emulation system according to claim 2, characterized in that the input unit(28) of a logic cell(30) comprises an interrogation unit(40).

4. An electronic hardware emulation system according to claim 1 or 3, characterized in that the delay elements(34,47) are programmed over RAMs(32,43).

5. An electronic hardware emulation system according to claim 4, characterized in that an input unit(28) of a logic cell(30) comprises, starting from a wiring bus(31), a multiplexer(33), a subsequent delay unit(34), a subsequent multiplexer(35) and an interrogation unit(40), the multiplexer(33), the delay element(34) and the multiplexer(35) programmed over a RAM(32).

6. An electronic hardware emulation system according to claim 5, characterized in that the output of the input units(28) is connected with a selectable logic function unit(41) of the logic cell(30).

7. An electronic hardware emulation system according to claim 6, characterized in that the selectable logic function unit(41) and the multiplexer(45), the delay element(47) and the demultiplexer(48) of the output signal line are programmed over a common RAM(43).

8. An electronic hardware emulation system according to claim 7, characterized in that an input unit(28) comprises a direct connection(42) with the input of the multiplexer(45) of the output unit(29) of the logic cell(30), so that, with corresponding programming, the logic function unit(41) can be by-passed.

9. An electronic hardware emulation system according to claim 8, characterized in that the delay elements(34,47,86) can be digitally be graded within a given range.

10. An electronic hardware emulation system according to claim 9, characterized in that a multitude of said logic cells( FPE cells)(30) are combined to FPE modules(60) by means of a wiring bus(61).

11. An electronic hardware emulation system according to claim 10, characterized in that several FPE modules(60) are connected with each other over free-programmable coupling fields(71).

12. An electronic hardware emulation system according to claim 11, characterized in that the free-programmable coupling fields(71) are provided with delay elements(86).

13. An electronic hardware emulation system according to claim 12, characterized in that in each signal line(81) of a coupling field(71), a delay element(86) is inserted.

14. An electronic hardware emulation system according to claim 13, characterized in that each delay element(86) is programmable by means of a RAM(87).

15. An electronic hardware emulation system according to claim 14, characterized in that each intersection of a signal line(81,82) of the coupling field(71) with another signal line(81,82) of the coupling field(71) is programmable by means of a RAM(88).

16. An electronic hardware emulation system according to claim 13, characterized in that the delay elements(86) are fine-graded.

17. An electronic hardware emulation system according to any one of the preceeding claims, characterized in that the inputs *In* of the logic function unit(41) can be connected, over the multiplexers(35), to fixed logic potentials *Fn* of the RAM(32).

## Revendications

1. Système matériel d'émulation, se composant de plusieurs cellules logiques configurables reliées entre elles en blocs logiques, cellules I/O configurables d'une connexion configurable, des éléments retardateurs (34, 47) programmables étant ajoutés à chaque cellule logique (30),
**caractérisé en ce que**
chaque unité de sortie (29) d'une cellule logique (30) présente au moins une unité d'appel (46), un autre élément retardateur (47) et un démultiplexeur (48).

2. Système matériel d'émulation selon revendication 1, **caractérisé en ce qu'** un élément retardateur (34) programmable est ajouté à chaque unité d'entrée (28) d'une cellule logique (30).

3. Système matériel d'émulation selon revendication 2,
**caractérisé en ce que** l'unité d'entrée (28) d'une cellule logique (30) comprend une unité d'appel (40).

4. Système matériel d'émulation selon revendication 1 ou 3, **caractérisé en ce que** les éléments retardateurs (34, 47) sont programmables au moyen de mémoires à accès direct (32, 43).

5. Système matériel d'émulation selon revendication 4, **caractérisé en ce qu'** une unité d'entrée (28) d'une cellule logique (30) présente en partant d'un bus de connexion (31) un multiplexeur (33), un élément retardateur (34) raccordable, un multiplexeur consécutif (35) et une unité d'appel (40), le multiplexeur (33), l'élément retardateur (34) et le multiplexeur (35) étant programmables au moyen d'une mémoire à accès direct (32).

6. Système matériel d'émulation selon revendication 5, **caractérisé en ce que** la sortie des unités d'entrée (28) est reliée à une unité fonctionnelle logique sélectionnable (41) de la cellule logique (30).

7. Système matériel d'émulation selon revendication 6, **caractérisé en ce que** l'unité fonctionnelle logique sélectionnable (41) et le multiplexeur (45), l'élément retardateur (47) et le démultiplexeur (48) de la ligne de communication de sortie sont programmables au moyen d'une mémoire commune à accès direct (43).

8. Système matériel d'émulation selon revendication 7, **caractérisé en ce qu'** une unité d'entrée (28) présente une liaison directe (42) avec l'entrée du multiplexeur (45) de l'unité de sortie (29) de la cellule logique (30), de telle manière que l'unité fonctionnelle logique (41) peut être contournée par programmation correspondante.

9. Système matériel d'émulation selon revendication 8, **caractérisé en ce que** les éléments retardateurs (34, 47, 86) sont numériquement échelonnables à l'intérieur d'une étendue donnée.

10. Système matériel d'émulation selon revendication 9, **caractérisé en ce que** plusieurs cellules logiques (cellules FPE) (30) sont regroupées en modules FPE (60) au moyen d'un bus de connexion (61).

11. Système matériel d'émulation selon revendication 10, **caractérisé en ce que** plusieurs modules FPE (60) sont reliés entre eux par des champs de couplage (71) librement programmables.

12. Système matériel d'émulation selon revendication 11, **caractérisé en ce que** les champs de couplage (71) librement programmables sont pourvus d'éléments retardateurs (86).

13. Système matériel d'émulation selon revendication 12, **caractérisé en ce qu'** un élément retardateur (86) est ajouté à chaque ligne de communication (81) d'un champ de couplage (71).

14. Système matériel d'émulation selon revendication 13, **caractérisé en ce que** chaque élément retardateur (86) est programmable au moyen d'une mémoire à accès direct (87).

15. Système matériel d'émulation selon revendication 14, **caractérisé en ce que** chaque croisement d'une ligne de communication (81, 82) du champ de couplage (71) avec une autre ligne de communication (81, 82) du champ de couplage (71) est programmable au moyen d'une mémoire à accès direct (88).

16. Système matériel d'émulation selon revendication 13, **caractérisé en ce que** les éléments retardateurs (86) sont finement échelonnables.

17. Système matériel d'émulation selon l'une des revendications précédentes, **caractérisé en ce que** les entrées *In* de l'unité fonctionnelle logique (41) peuvent au moyen des multiplexeurs (35) être définies sur des potentiels logiques fixes *Fn* de la mémoire à accès direct (32).
